# EUROPÄISCHE PATENTANMELDUNG

(11) **EP 1 499 020 A1**
(43) Veröffentlichungstag der Anmeldung: **19.01.2005**
(21) Anmeldenummer: 03016252.3
(22) Anmeldetag: 17.07.2003
(51) Int. Cl.: H03H 7/38, H03H 11/28

(54) **Schaltungsanordnung und Verfahren zur Anpassung der Stromaufnahme und der Ausgangsleistung von Leistungsverstärkern in Mobilfunktelefonen an verschiedene Umgebungsbedingungen**

(71) Anmelder: SIEMENS AKTIENGESELLSCHAFT, 80333 München (DE)
(72) Erfinder: Schmalzl, Stefan, 80797 München (DE)

(57) **Zusammenfassung**

Die Erfindung betrifft eine Schaltungsanordnung und ein Verfahren zur Anpassung der Stromaufnahme und der Ausgangsleistung von Leistungsverstärkern (17) in Mobilfunktelefonen an verschiedene Umgebungsbedingungen bei der/dem zumindest ein Leistungsverstärker (17) Signale an eine Antenne (20) am Ausgang (17.2) des Leistungsverstärkers (17) ausgibt, wobei die Antenne (20) eine bestimmte Impedanz (20) aufweist und je nach Lastimpedanz am Ausgang (17.2) des Leistungsverstärkers (17) die Ausgangsleistung und/oder die Stromaufnahme des Leistungsverstärkers variieren/variiert.

Die Erfindung zeichnet sich dadurch aus, dass mit mindestens einem schaltbaren Anpassnetzwerk (16) zwischen Ausgang (17.2) des Leistungsverstärkers (17) und der Antenne (20), die Lastimpedanz am Ausgang (17.2) des Leistungsverstärkers (17) verändert werden kann.

## Beschreibung

Die Erfindung betrifft eine Schaltungsanordnung und ein Verfahren zur Anpassung der Stromaufnahme und der Ausgangsleistung von Leistungsverstärkern in Mobilfunktelefonen an verschiedenen Umgebungsbedingungen, bei der/dem zumindest ein Leistungsverstärker Signale an eine Antenne am Ausgang des Leistungsverstärkers ausgibt, wobei die Antenne eine bestimmte Impedanz aufweist und je nach Lastimpedanz am Ausgang des Leistungsverstärkers die Ausgangsleistung und/oder die Stromaufnahme des Leistungsverstärkers variieren/variiert.

Mobilfunktelefone werden über einen weiten Temperatur- und Spannungsbereich betrieben. Insbesondere für den Leistungsverstärker (PA) bedeutet dies besonders hohe Anforderungen. So ist die Performance, also die Ausgangsleistung, der Wirkungsgrad und die Stabilität eines Leistungsverstärkers sehr stark von verschiedenen Umgebungsparametern, wie zum Beispiel der Temperatur, der Versorgungsspannung und der Frequenz, abhängig.

Ein GSM-Leistungsverstärker muss aufgrund der Anforderung der 3GPP (3rd Generation Partnership Project) 45.005 bei einer Umgebungstemperatur des Mobilfunktelefons von 55 Grad Celsius und einer typischen minimalen Versorgungsspannung von 3.1 Volt im TX-Burst eine Ausgangsleistung im Bereich von 32 bis 33 dBm liefern, wobei Schwankungen aufgrund einer spezifischen Implementierung möglich sind. Hierbei entspricht ein dBm, der mit dem Faktor 10 multiplizierte logarithmische Leistung bezogen auf ein Milliwatt Leistung. Für diese Anforderung werden die Transistoren des Leistungsverstärkers dimensioniert und konzipiert.

Da Leistungsverstärker normalerweise auf den in der Praxis eher seltenen Fall der minimalen Versorgungsspannung bei gleichzeitiger maximaler Temperatur dimensioniert werden, kann bei Raumtemperatur und normaler Versorgungsspannung - typischerweise 3.5 Volt bei GMSK-Leistungsverstärkern der Leistungsverstärker deutlich mehr Sättigungsleistung liefern, als zum Erreichen der Nominalleistung notwendig ist. Der Leistungsverstärker wird daher bei diesen Bedingungen mit einem Back-off von typischerweise 2 bis 3 dB betrieben. Back-off bezeichnet hier die Differenz zwischen der eingestellten Ausgangsleistung und der maximalen Ausgangsleistung des Leistungsverstärkers. Diese Betriebsweise mit Back-off verschlechtert den Wirkungsgrad bei Nominalleistung drastisch, da nur im Bereich der Sättigungsleistung bei GSM-Leistungsverstärkern die maximale Effektivität im Bereich von typischerweise 50 % erreicht wird. Der Leistungsverstärker ist also für den Extremfall, der zudem noch selten auftritt, dimensioniert. Bei Normalbedingungen führt dies zu einer Überdimensionierung auf Kosten der Effektivität.

Ein weiteres Problem, das sich durch den Einsatz von Mobilfunktelefonen unter verschiedenen Umgebungsbedingen ergibt, ist, dass der Leistungsverstärker bei Fehlanpassung, also zum Beispiel beim Abdecken der Antenne, unverhältnismäßig viel Strom aufnehmen kann.

Diese zum Teil unnötig hohe Stromaufnahme hat eine kürzere Lebensdauer des Akkus, des Leistungsverstärkers selbst sowie kürzere Sprech- und Standby-Zeiten des Mobilfunktelefons zur Folge. Insbesondere der Trend zur Miniaturisierung der Mobilfunktelefone mit der einhergehenden Verkleinerung der Akkus und deren Kapazitäten macht ein gezieltes "Strommanagement" notwendig.

Es ist daher Aufgabe der Erfindung, eine Schaltungsanordnung vorzustellen, welche die Effektivität und die Ausgangsleistung des Leistungsverstärkers unter verschiedenen Umgebungsbedingungen verbessert, wobei unter Umgebungsbedingungen zum Beispiel die Umgebungstemperatur, die Versorgungsspannung, die Frequenz des Leistungsverstärkers und der Betrieb des Leistungsverstärkers über interne oder externe Antenne zu verstehen sind. Weiterhin ist es Aufgabe der Erfindung, ein entsprechendes Verfahren vorzustellen.

Diese Aufgaben der Erfindung werden gegenständlich durch eine Schaltungsanordnung mit den Merkmalen des Patentanspruches 1 und durch den Verfahrensanspruch 15 gelöst. Vorteilhafte Weiterbildungen der Erfindung sind Gegenstand untergeordneter Patentansprüche.

Die Erfinder haben erkannt, dass die Ausgangsleistung und die Effektivität eines Leistungsverstärkers abhängig von der Lastimpedanz (Load State) am Ausgang des Leistungsverstärkers sind. Der Load State für maximale Leistung und der Load State für maximale Effektivität sind jedoch normalerweise unterschiedlich. Wird zwischen dem Load State für maximale Leistung und dem Load State für maximale Effektivität umgeschaltet, so kann entweder die Effektivität oder die Ausgangsleistung des Leistungsverstärkers erhöht werden.

Entsprechend diesem Erfindungsgedanken schlagen die Erfinder vor, eine Schaltungsanordnung zur Anpassung der Stromaufnahme und der Ausgangsleistung von Leistungsverstärkern in Mobilfunktelefonen an verschiedene Umgebungsbedingungen, mindestens bestehend aus: einem Leistungsverstärker mit einer internen und/oder externen Antenne und zwischen Leistungsverstärker und Antenne angeordnetem Frontend, wobei die Antenne und das Frontend eine Last am Ausgang des Leistungsverstärkers bilden, die eine bestimmte Impedanz aufweist und die Stromaufnahme und die Ausgangsleistung des Leistungsverstärkers abhängig von der Lastimpedanz am Ausgang des Leistungsverstärkers sind, dahingehend zu verbessern, dass zwischen dem Ausgang des Leistungsverstärkers und dem Eingang des Frontends mindestens ein schaltbares Anpassnetzwerk angeordnet ist, das die Lastimpedanz am Ausgang des Leistungsverstärkers verändern kann, wobei die Last des Leistungsverstärkers durch interne oder externe Antenne und dem Frontend zwischen Leistungsverstärker und interner beziehungsweise externer Antenne bestimmt wird.

Frontend bezeichnet hier eine Komponente, die die verschiedenen RX- und TX-Pfade eines Mobilfunktelefons mit der internen und/oder externe Antenne verbindet. Stand der Technik bei GSM sind beispielsweise Multiband-Frontend Module mit integriertem Diplexer, RX/TX-Switch und vollständiger RX- und TX- Filterung.

Hierdurch besteht sehr einfach die Möglichkeit bei sich ändernden Umgebungsparametern des Leistungsverstärkers, wie zum Beispiel Änderung der Temperatur, der Versorgungsspannung der Frequenz und des Betriebs des Leistungsverstärkers über interne und/oder externe Antenne, sowohl die Effektivität, durch eine niedrigere Stromaufnahme, als auch die Ausgangsleistung des Leistungsverstärkers zu optimieren. Somit kann der Leistungsverstärker über einen großen Einsatzbereich, hinsichtlich Temperatur, Versorgungsspannung und Frequenz wahlweise mit einer hohen Ausgangsleistung oder mit einer hohen Effizienz betrieben werden.

Das Anpassnetzwerk sollte zumindest zwei schaltbare Zustände aufweisen. Es ist durch das schaltbare Anpassnetzwerk durchaus möglich mehr als zwei schaltbare Zustände einzustellen. Dies kann zum Beispiel dann günstig sein, wenn der Leistungsverstärker nicht nur mit maximaler Leistung oder maximaler Effektivität betrieben werden soll, sondern auch Zwischenzustände erzeugt werden sollen.

Sind nur zwei schaltbare Zustände vorhanden, so ist es günstig, wenn ein erster schaltbarer Zustand vorgesehen ist, der eine Lastimpedanz am Ausgang des Leistungsverstärkers erzeugt, bei der der Leistungsverstärker maximale Ausgangsleistung aufweist. So kann zum Beispiel bei niederer Versorgungsspannung, beispielsweise 3.1 Volt, und hohen Umgebungstemperaturen, beispielweise mehrere Grad Celsius über der Zimmertemperatur, mit Hilfe des ersten schaltbaren Zustandes die erforderliche Leistung des Leistungsverstärkers für diese "Extrembedingungen" zur Verfügung gestellt werden.

Es ist analog dazu auch günstig, wenn ein zweiter schaltbarer Zustand vorgesehen ist, der eine Lastimpedanz erzeugt, bei der der Leistungsverstärker maximale Effektivität aufweist. Bei normaler und hoher Versorgungsspannung, beispielsweise größer als 3.5 Volt und normaler Umgebungstemperaturen, beispielweise Zimmertemperatur circa 22 Grad Celsius, wird mit Hilfe des zweiten schaltbaren Zustandes eine hohe Effektivität des Leistungsverstärkers zur Verfügung gestellt. In diesem Zustand kann somit die Stromaufnahme des Leistungsverstärkers reduziert werden.

Bisher wurde ein derartiges "Schalten" zwischen "Zuständen" nicht praktiziert. Es wurde vielmehr am Ausgang des Leistungsverstärkers eine feste Impedanz gewählt, die einen Kompromiss hinsichtlich hoher Leistung und hoher Effektivität darstellte.

Es ist vorteilhaft, wenn das Anpassnetzwerk in Abhängigkeit der Sendefrequenz des Leistungsverstärkers schaltbar ausgeführt ist. Die Variante ist vor allem im Hinblick auf die Load Pull Charakteristik interessant, da diese eine Frequenzabhängigkeit aufweist. Die Load Pull Charakteristik beschreibt die Ausgangsleistung des Leistungsverstärkers in Abhängigkeit der Lastimpedanz. Hierdurch kann die Effektivität und die Ausgangleistung von Leistungsverstärkern in Multimode-Mobiltelefonen angepasst werden, die in unterschiedlichen Frequenzbereichen operieren.

Das Anpassnetzwerk kann zumindest ein schaltendes Element, beispielsweise eine PIN-Diode und zugehöriger Ansteuerung, zum Beispiel ein Dioden-Biasing, aufweisen, das am Ausgang des Leistungsverstärkers angeordnet ist.

Beispielhaft wird der Fall der PIN-Diode als schaltendes Element erläutert. Mit der zumindest einen PIN-Diode, die im Durchlassbereich und im Sperrbereich betrieben werden kann, können die schaltbaren Zustände sehr einfach realisiert werden. Der undotierte oder schwach dotierte intrinsische Bereich der PIN-Diode ermöglicht höhere Durchbruchspannungen.

Neben PIN-Dioden können auch andere schaltende Elemente wie MEMS-Schalter (Micro Electrical Mechanical Switch) eingesetzt werden.

Es ist vorteilhaft, wenn das schaltende Element und die Steuerlogik im Leistungsverstärker integriert sind. Hierdurch wird eine Integration der neuen Schaltungsanordnung im Mobilfunktelefon erleichtert und gleichzeitig eine kompaktere Gestaltung des Mobilfunktelefons ermöglicht.

Analog können die schaltenden Elemente und die Steuerlogik auch im Frontend integriert sein.

Dass Anpassnetzwerk sollte zumindest einen Energiespeicher, zum Beispiel eine Kapazität und/oder eine Induktivität, aufweisen. Durch das Anpassnetzwerk wird die Lastimpedanz auf eine gewünschte Impedanz abgebildet, wobei die Abbildung durch Topologie und Bauteilwerte bestimmt wird.

Es kann vorteilhaft sein, dass das Anpassnetzwerk als Phasenschiebernetzwerk ausgeführt ist, welches die Impedanz am Ausgang des Leistungsverstärkers hinsichtlich der Phase dreht.

Messungen der Erfinder an Leistungsverstärkern haben ergeben, dass die Stromaufnahme besonders vom Winkel des Reflexionsfaktors abhängt. Durch das Phasenschiebernetzwerk, das in dem Pfad zwischen Ausgang des Leistungsverstärkers und der Antenne angeordnet ist, kann der Impedanzwert am Ausgang des Leistungsverstärkers in einen Bereich gedreht werden, in dem die Stromaufnahme einen geringeren Wert aufweist.

Bei Leistungsverstärkern mit integrierter Frontendfunktionalität wird vorgeschlagen, das Phasenschiebernetzwerk mit im Leistungsverstärker zu integrieren. Leistungsverstärker mit Frontendfunktionalität sind Anordnungen, die zusätzlich zu dem Leistungsverstärker frontendtypische Element, wie Filter für Harmonische, RX/TX Switch, Diplexer, Duplexer, aufweisen. Die Zustände oder die gewünschte Phase können über Steuersignale eingestellt werden.

Ein solches Phasenschiebernetzwerk lässt sich besonders einfach als analoger Phasenschieber zum Beispiel in Form von Kapazitätsdioden in der Schaltungsanordnung implementieren.

Das Phasenschiebenetzwerk kann aber auch als digitaler Phasenschieber, beispielsweise als schaltbare Verzögerungsleitung, ausgeführt sein.

Entsprechend der Schaltungsanordnung schlagen die Erfinder auch ein Verfahren zur Anpassung der Stromaufnahme und der Ausgangsleistung von Leistungsverstärkern in Mobilfunktelefonen an verschiedene Umgebungsbedingungen vor, bei dem zumindest ein Leistungsverstärker Signale an eine Antenne am Ausgang des Leistungsverstärkers ausgibt, wobei die Antenne in Abhängigkeit der momentanen Umgebungsbedingungen eine bestimmte Impedanz aufweist und je nach Lastimpedanz am Ausgang des Leistungsverstärkers die Ausgangsleistung und/oder die Stromaufnahme des Leistungsverstärkers variieren/variiert, wobei das Verfahren dadurch gekennzeichnet ist, dass mit mindestens einem schaltbaren Anpassnetzwerk zwischen Ausgang des Leistungsverstärkers und der Antenne die Lastimpedanz am Ausgang des Leistungsverstärkers verändert werden kann.

Hierdurch besteht sehr einfach die Möglichkeit, bei sich ändernden Umgebungsparameter des Leistungsverstärkers, wie zum Beispiel Änderung der Temperatur, der Versorgungsspannung und der Frequenz, sowohl die Effektivität als auch die Ausgangsleistung des Leistungsverstärkers an die geänderten Umgebungsparameter anzupassen. Somit kann der Leistungsverstärker über einen großen Einsatzbereich, hinsichtlich Temperatur, Versorgungsspannung und Frequenz mit sehr hoher Effektivität, hoher Ausgangsleistung und minimalem Stromaufnahme betrieben werden.

Es ist günstig, wenn im Verfahren zumindest zwei schaltbare Zustände eingestellt werden können. Über das Anpassnetzwerk kann in einem ersten schaltbaren Zustand eine Lastimpedanz am Ausgang des Leistungsverstärkers erzeugt werden, bei der der Leistungsverstärker maximale Ausgangsleistung aufweist. So kann zum Beispiel bei niederer Versorgungsspannung beispielsweise 3.1 Volt und hohen Umgebungstemperaturen beispielweise mehrere Grad Celsius über der Zimmertemperatur, mit Hilfe des ersten schaltbaren Zustandes die erforderliche Leistung des Leistungsverstärkers für diese "Extrembedingungen" zur Verfügung gestellt werden.

Es ist analog dazu auch günstig, wenn ein zweiter schaltbarer Zustand eine Lastimpedanz erzeugt, bei der der Leistungsverstärker maximale Effektivität aufweist. Bei normaler und hoher Versorgungsspannung, beispielsweise größer als 3.5 Volt, und normaler Umgebungstemperaturen, beispielweise Zimmertemperatur circa 22 Grad Celsius, kann mit Hilfe des zweiten schaltbaren Zustandes eine hohe Effektivität des Leistungsverstärkers zur Verfügung gestellt werden. In diesem Zustand kann somit die Stromaufnahme des Leistungsverstärkers reduziert werden.

Durch das Schalten zwischen diesen zwei Zuständen ist es möglich, den Leistungsverstärker, je nach Umgebungsbedingung, mit maximaler Leistung oder mit maximaler Effektivität zu betreiben. Die bisherige Kompromisslösung, bei der eine feste Lastimpedanz eingesetzt wurde, die als Kompromiss zwischen maximaler Leistung und maximaler Effektivität ausgelegt ist, wobei aber die jeweiligen Maximalwerte des Leistungsverstärkers nicht erreicht wurden, ist nun nicht mehr notwendig.

Es ist weiterhin günstig, wenn das Anpassnetzwerk frequenzabhängig geschaltet wird. Diese Variante ist vor allem im Hinblick auf die Load Pull Charakteristik interessant, da diese eine Frequenzabhängigkeit aufweist. Außerdem kann hierdurch auch die Effektivität von Leitungsverstärkern in Multimode-Mobiltelefonen angepasst werden, die in unterschiedlichen Frequenzbereichen operieren. So kann das Anpassnetzwerk beispielsweise in Abhängigkeit der Sendefrequenz des Leistungsverstärkers geschaltet werden.

Da die Performance eines Leistungsverstärkers abhängig von der Umgebungstemperatur ist, sollte das Anpassnetzwerk in Abhängigkeit der Temperatur geschaltet werden.

Aber auch eine Schaltweise des Anpassnetzwerkes in Abhängigkeit der Betriebsweise über interne oder externe Antenne wird von den Erfindern vorgeschlagen.

Es kann vorteilhaft sein, dass die Impedanz am Ausgang des Leistungsverstärkers hinsichtlich der Phase gedreht wird. Messungen der Erfinder an Leistungsverstärkern haben ergeben, dass die Stromaufnahme besonders vom Winkel des Reflexionsfaktors abhängt. Durch das Phasenschiebernetzwerk zwischen dem Ausgang des Leistungsverstärkers und der Antenne kann der Impedanzwert am Ausgang des Leistungsverstärkers in einen Bereich gedreht werden, in dem die Stromaufnahme einen geringeren Wert aufweist.

Die Impedanz am Ausgang des Leistungsverstärkers kann sowohl analog als auch digital gedreht werden.

Diese Möglichkeiten können durch ein analoges Phasenschiebernetzwerk realisiert werden, zum Beispiel in Form von Kapazitätsdioden, oder durch ein digitales Phasenschiebernetzwerk beispielsweise als schaltbare Verzögerungsleitung.

Weitere Merkmale der Erfindung ergeben sich aus der nachfolgenden Beschreibung der Ausführungsbeispiele unter Bezugnahme auf die Zeichnungen.

Im folgenden wird die Erfindung anhand der Zeichnungen näher beschrieben:
- Figur 1:: Reflexionsfaktordiagramm (Smith-Chart), in dem die Ausgangsleistung eines GSM-Leitungsverstärkers für eine bestimmte Impedanz aufgetragen ist;
- Figur 2:: Reflexionsfaktordiagramm (Smith-Chart), in dem die Effektivität eines GSM-Leitungsverstärkers für eine bestimmte Impedanz aufgetragen ist;
- Figur 3:: Reflexionsfaktordiagramm (Smith-Chart), in dem die Stromaufnahme eines GSM-Leitungsverstärkers für eine bestimmte Impedanz aufgetragen ist;
- Figur 4:: Reflexionsfaktordiagramm (Smith-Chart) für verschiedene Antennenimpedanzwerte, wobei die Antenne unterschiedlich abgedeckt ist;
- Figur 5:: Leistungsverstärker mit Anpassnetzwerk;
- Figur 6:: Zwei Leistungsverstärker mit Phasenschiebernetzwerk.

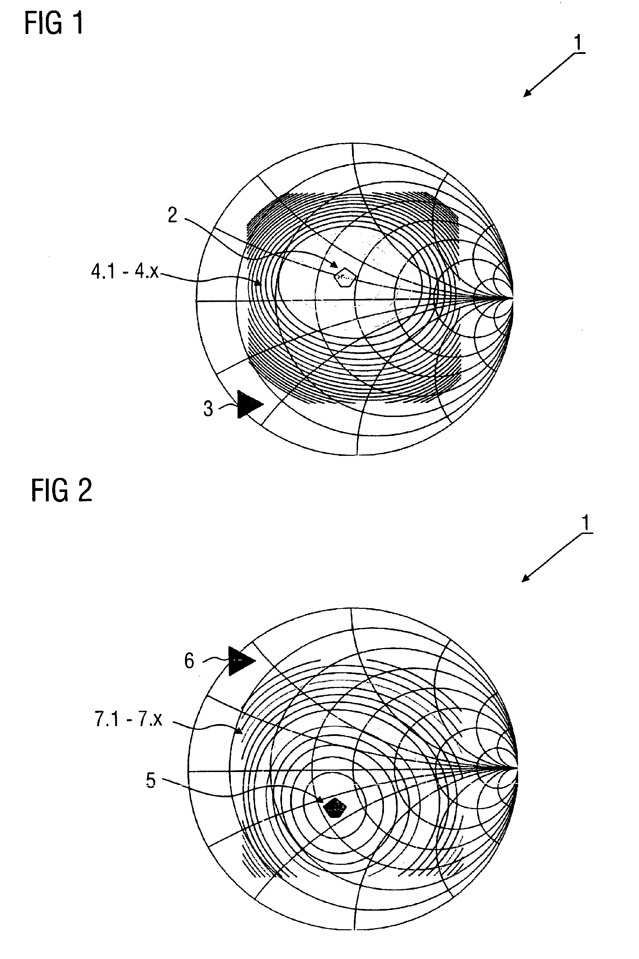

Die Figur 1 zeigt die Load Pull Charakteristik eines GSM-Leistungsverstärkers dargestellt in einem Smith Chart 1. Im Smith-Chart 1 der Figur 1 wird die Ausgangsleistung eines GSM-Leitungsverstärkers nämlich des *GSM PA RF 9340* der Firma Micro Devices dargestellt, die an eine bestimmte Impedanz am Ausgang des GSM-Leistungsverstärkers abgegeben wird. Das Fünfeck in Figur 1 entspricht der maximalen Leistung 2, oder auch Load State für maximale Leistung 2 genannt. Der Load State für maximale Leistung 2 hat hier einen Wert von 35,7 dBm bei einem Winkel von +112,2 Grad. Das Dreieck entspricht der minimalen Leistung 3, hier 24 dBm bei einem Winkel von - 135,3 Grad. Die nahezu konzentrischen ringförmigen und geschlossenen Linien um das Fünfeck zeigen Konturlinien mit konstanter Leistung 4.1 bis 4.x. Auf einer Konturlinie 4.n wird für eine bestimmte Impedanz immer der gleiche Ausgangsleistungswert des GSM-Leistungsverstärkers erhalten. Zwei benachbarte Konturlinien 4.n und 4.n+1 weisen voneinander einen Leistungsabstand von 0,25 dB auf.

Die Figur 2 zeigt ein Smith-Chart 1, in dem die Effektivität des Leistungsverstärkers *GSM PA RF 9340,* der eine Frequenz von 902 MHz hat, dargestellt ist, die an eine bestimmte Impedanz abgeben wird. In Figur 2 entspricht das Fünfeck dem Maximum der Effektivität 5 und das Dreieck dem Minimum der Effektivität 6. Das Maximum der Effektivität 5 oder Load State für maximale Effektivität 5 liegt bei einem Wert von circa 49,7 %, bei einem Winkel von -115,6 Grad. Das Minimum der Effektivität 6 liegt bei einem Wert von circa 2,5 %, bei einem Winkel von +134,6 Grad. Die nahezu konzentrischen ringförmigen und geschlossenen Linien um das Fünfeck zeigen Konturlinien mit konstanter Effektivität 7.1 bis 7.x. Auf einer Konturlinie 7.n wird für eine bestimmte Impedanz der gleiche Effektivitätswert des Leistungsverstärkers erhalten. Zwei benachbarte Konturlinien 7.n und 7.n+1 weisen voneinander einen Abstand in der Effektivität von 2,5 % auf.

Wie aus den beiden Smith-Charts 1 und den Messwerten aus den Figuren 1 und 2 zu entnehmen ist, wird der Load State für maximale Leistung 2 und der Load State für maximale Effektivität 5 bei unterschiedlichen Werten erreicht. Prinzipiell tritt dieses Phänomen bei allen Leistungsverstärkern auf. In der Praxis wählt man daher bisher eine feste Impedanz am Ausgang des Leistungsverstärkers, die einen Kompromiss zwischen maximaler Leistung und maximaler Effektivität, darstellt.

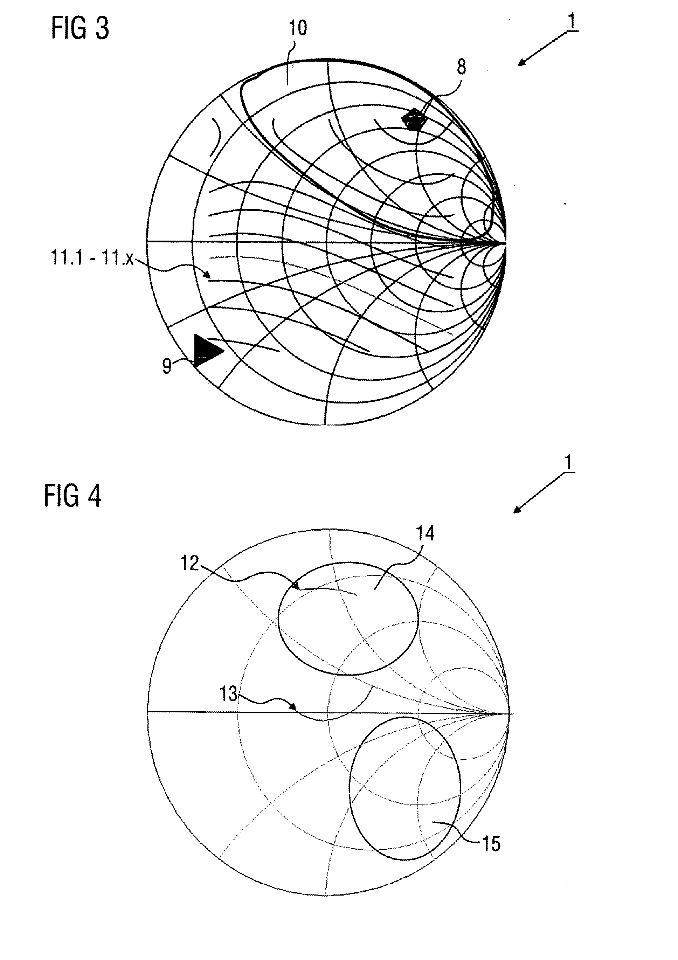

Die Figur 3 zeigt in einem weiteren Smith-Chart 1 Stromkonturen eines GSM-Leistungsverstärkers, nämlich des *GSM PA RF9340.* Das Fünfeck entspricht dem Maximum der Stromaufnahme 8 und das Dreieck dem Minimum der Stromaufnahme 9. Die Linien zwischen dem Fünfeck und dem Dreieck entsprechen Konturlinien 11.1 bis 11.x bei denen die Stromaufnahme des Leistungsverstärkers konstant ist. Diese Konturlinien 11.1 bis 11.x haben einen Abstand in der Stromaufnahme von 100 Milliampere. Der in Form einer Blase eingerahmte Bereich 10 in der oberen Hälfte des Smith-Charts 1 entspricht einem Bereich 10, in dem die Stromaufnahme des GSM-Leistungsverstärkers hoch ist.

Die Figur 4 zeigt ein Smith-Chart 1 für verschiedene Antenneimpedanzwerte, wobei die Antenne unterschiedlich abgedeckt ist. Das in Form einer Ellipse eingerahmte Feld in der oberen Hälfte des Smith-Charts 1 zeigt den Bereich 14 der Impedanzen einer Antenne bei unterschiedlicher starker Abdeckung der Antenne. Die Antenne kann zum Beispiel mit der Hand unterschiedlich stark abgedeckt werden. Dies ist zum Beispiel bei kleinen Mobilfunktelefonen der Fall, bei denen die Antenne im Gerät integriert ist und die Antenne somit bereits durch das Halten des Mobilfunktelefons in der Hand abgedeckt wird. Das in Form einer Ellipse eingerahmte Feld mit dem Bezugszeichen 15 in der unteren Hälfte des Smith-Charts 1 zeigt den Impedanzbereich der oberen Hälfte, jedoch um λ/8 (λ bezeichnet hierbei die Wellenlänge) in der Phase gedreht. Die gebogene Linie in der Mitte des Smith-Charts 1 zeigt die Impedanz einer Antenne 13 in einem Frequenzbereich von 880 MHz bis 915 MHz, die ins freie Feld abstrahlt. Wobei eine Frequenz von einem MHz 1000000 Hertz [= 1/Sekunde] entspricht. Die gebogene Linie, die innerhalb des Feldes mit dem Bezugszeichen 14 in der oberen Hälfte des Smith-Charts 1 liegt, zeigt die Impedanz einer Antenne 14 im Bereich von 880 MHz bis 915 MHz, die abgedeckt ist. Durch Drehung der Phase um λ/8 kann die Impedanz einer abgedeckten Antenne in einen günstigeren Impedanzbereich verschoben beziehungsweise gedreht werden.

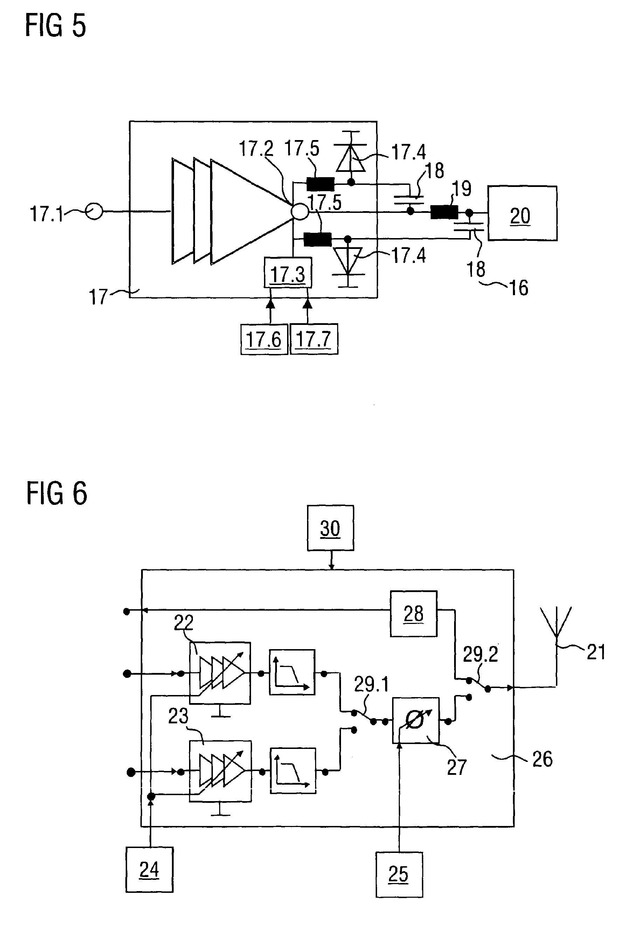

Die Figur 5 zeigt eine Schaltungsanordnung bestehend aus einem Leistungsverstärker 17 mit Anpassnetzwerk 16. Der Leistungsverstärker 17 verfügt über einen Signaleingang 17.1 und einen Signalausgang 17.2. Am Signalausgang 17.2 wird eine Antenne angeschlossen. Dies ist in Figur 5 durch die Impedanz 20 der Antenne symbolisiert. Das Anpassnetzwerk 16 am Signalausgang 17.2 des Leistungsverstärkers verändert die Lastimpedanz am Signalausgang 17.2. In dieser besonderen Ausführung besteht das Anpassnetzwerk 16 aus einer Ansteuerlogik 17.3, mehreren PIN-Dioden 17.4 und den Dioden-Biasing 17.5, aus mehreren Kapazitäten 18 und Induktivität 19. Die PIN-Dioden 17.4, die Kapazitäten 18 und die Induktivität 19 sind derart in Reihe oder parallel geschaltet, dass mit der Steuerlogik und den Steuersignalen Vc1 17.6 und Vc2 17.7 über das Anpassnetzwerk 16 zumindest zwei schaltbare Zustände geschaltet werden können. Diese schaltbaren Zustände erzeugen zwei unterschiedliche Lastimpedanzen. Das Besondere an dieser Schaltungsanordnung ist, dass die PIN-Dioden 17.4, die Dioden-Biasing 17.5 und die Steuerlogik 17.3 im Leistungsverstärker 17 integriert sind. Hierdurch ergibt sich eine besonders vorteilhafte Implementierung des Anpassnetzwerkes 16 im Mobilfunktelefon, wodurch der zunehmenden Miniaturisierung im Mobilfunkbereich Rechnung getragen wird. Statt PIN-Dioden können auch MEMS verwendet werden.

Die Figur 6 zeigt eine besondere Schaltungsanordnung. Diese Schaltungsanordnung verfügt über zwei unterschiedliche Leistungsverstärker. Es ist sowohl ein GSM-Leistungsverstärker 22 als auch ein PCN/PCS-Leistungsverstärker 23 innerhalb der Schaltungsanordnung angeordnet. Zusätzlich sind noch frontendtypische Funktionalitäten, wie Filter und RX-/TX-Switch, enthalten, die aber in Figur 6 nicht dargestellt sind. Über eine Antenne 21 können sowohl Signale gesendet als auch empfangen werden. Mit Hilfe des zweiten Schalters 29.2 kann entweder eine Verbindung zum Sendebetrieb oder zum Empfangbetrieb, bei dem RX-Filter Switches 28 zwischengeschaltet sind, geschaltet werden. Um die Lastimpedanz am Ausgang der beiden Leistungsverstärker 22 und 23 verändern zu können, ist in dieser Schaltungsanordnung ein Phasenschiebernetzwerk 26 mit Phasenschieber 27 angeordnet. Durch Drehung der Phase wird der Impedanzwert geändert. Der Phasenschieber 27 kann über den ersten Schalter 29.1 sowohl mit dem Ausgang des GSM-Leistungsverstärkers 22, als auch mit dem Ausgang des PCN/PCS-Leistungsverstärkers 23 verbunden werden. Somit kann an beiden Leistungsverstärkern 22 und 23 die Lastimpedanz am Ausgang gedreht werden.

Insgesamt wird also durch die Erfindung eine Schaltungsanordnung und ein Verfahren vorgestellt, die/das die Effektivität des Leistungsverstärkers unter verschiedenen Umgebungsbedingungen verbessert und gleichzeitig die Stromaufnahme des Leistungsverstärkers reduziert.

Es versteht sich, dass die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

### Liste der verwendeten Abkürzungen:

- dB: Dezibel
- dBm: Logarithmische Leistung in [dB] mit dem Faktor 10 multipliziert wird und bezogen auf ein Milliwatt Leistung
- FET: Feld Effekt Transistor
- 3GPP: Third (3^{rd}) Generation Partnership Project
- GSM: Global System for Mobile Communications (Mobilfunk)
- GMSK: Gaussian Minimum Shift Keying
- MEMS: Micro Electrical Mechanical Switch
- PA: Power Amplifier (Verstärker)
- PIN-Diode: Positive Intrinsic Negative Diode
- PCN: Personal Communication Network
- PCS: Personal Communication Services
- RX: Receiver
- TX: Transmitter

### Bezugszeichenliste

- 1: Reflexionsfaktordiagramm /Smith-Chart
- 2: Maximale Leistung (Fünfeck)
- 3: Minimale Leistung (Dreieck)
- 4.1 bis 4.x: Konturlinien für konstante Ausgangsleistung
- 5: Maximale Effektivität (Fünfeck)
- 6: Minimale Effektivität (Dreieck)
- 7.1 bis 7.x: Konturlinien für konstante Effektivität
- 8: Maximum der Stromaufnahme (Fünfeck)
- 9: Minimum der Stromaufnahme (Dreieck)
- 10: Bereich der hohen Stromaufnahme
- 11.1 bis 11.x: Konturlinien für konstante Stromaufnahme
- 12: Impedanz einer abgedeckten Antenne im Be reich von 880 MHz bis 915 MHz
- 13: Impedanz einer Antenne, die ins freie Feld abstrahlt im Bereich von 880 MHz bis 915 MHz
- 14: Impedanzbereich einer Antenne bei unterschiedlicher Abdeckung der Antenne
- 15: Impedanzbereich 14 bei Phasendrehung der Impedanz der Antenne um λ/8
- 16: Anpassnetzwerk
- 17: Leistungsverstärker PA
- 17.1: Signaleingang
- 17.2: Signalausgang
- 17.3: Steuerlogik (in PA integriert)
- 17.4: PIN-Diode (in PA integriert)
- 17.5: Dioden-Biasing (in PA integriert)
- 17.6: Steuersignal Vc1
- 17.7: Steuersignal Vc2
- 18: Kapazität (außerhalb des PA)
- 19: Induktivität(außerhalb des PA)
- 20: Impedanz der Antenne
- 21: Antenne
- 22: GSM-Leistungsverstärker
- 23: PCN/PCS-Leistungsverstärker
- 24: Power-Control Signal
- 25: Phase-Shifter-Control Signale
- 26: Phasenschiebernetzwerk
- 27: Phasenschieber
- 28: RX-Filter Switches
- 29.1: Erster Schalter
- 29.2: Zweiter Schalter
- 30: Mode-Switch Signale

## Patentansprüche

1. Schaltungsanordnung zur Anpassung der Stromaufnahme und der Ausgangsleistung von Leistungsverstärkern (17, 22 und 23) in Mobilfunktelefonen an verschiedene Umgebungsbedingungen, mindestens bestehend aus: einem Leistungsverstärker (17, 22 und 23) mit einer internen und/oder externen Antenne (21) und zwischen Leistungsverstärker (17, 22 und 23) und Antenne (21) angeordnetem Frontend, wobei die Antenne (21) und das Frontend eine Last am Ausgang (17.2) des Leistungsverstärkers bilden, die eine bestimmte Impedanz aufweist und die Stromaufnahme und die Ausgangsleistung des Leistungsverstärkers abhängig von der Lastimpedanz am Ausgang des Leistungsverstärkers sind, **dadurch gekennzeichnet, dass** zwischen dem Ausgang (17.2) des Leistungsverstärkers (17, 22 und 23) und dem Eingang des Frontends mindestens ein schaltbares Anpassnetzwerk (16 und 26) angeordnet ist, das die Lastimpedanz am Ausgang (17.2) des Leistungsverstärkers (17, 22 und 23) verändern kann.

2. Schaltungsanordnung gemäß dem voranstehenden Patentanspruch 1, **dadurch gekennzeichnet, dass** das Anpassnetzwerk (16 und 26) zumindest zwei schaltbare Zustände aufweist.

3. Schaltungsanordnung gemäß dem voranstehenden Patentanspruch 2, **dadurch gekennzeichnet, dass** ein erster schaltbarer Zustand vorgesehen ist, der eine Lastimpedanz erzeugt, bei der der Leistungsverstärker (17, 22 und 23) maximale Ausgangsleistung (2) aufweist.

4. Schaltungsanordnung gemäß einem der voranstehenden Patentansprüche 2 und 3, **dadurch gekennzeichnet, dass** ein zweiter schaltbarer Zustand vorgesehen ist, der eine Lastimpedanz erzeugt, bei der der Leistungsverstärker (17, 22 und 23) maximale Effektivität (5) aufweist.

5. Schaltungsanordnung gemäß einem der voranstehenden Patentansprüche 1 bis 4, **dadurch gekennzeichnet, dass** das Anpassnetzwerk (16 und 26) in Abhängigkeit der Sendefrequenz des Leistungsverstärkers (17, 22 und 23) schaltbar ausgeführt ist.

6. Schaltungsanordnung gemäß einem der voranstehenden Patentansprüche 1 bis 5, **dadurch gekennzeichnet, dass** das Anpassnetzwerk (16 und 26) zumindest ein schaltendes Element aufweist, vorzugsweise eine PIN-Diode (17.4) und ein Dioden-Biasing (17.5), die/das am Ausgang (17.2) des Leistungsverstärkers (17, 22 und 23) angeordnet ist/sind.

7. Schaltungsanordnung gemäß dem voranstehenden Patentanspruch 6, **dadurch gekennzeichnet, dass** das schaltende Element ein MEMS-Schalter oder ein FET-Schalter ist.

8. Schaltungsanordnung gemäß einem der voranstehenden Patentansprüche 1 bis 7, **dadurch gekennzeichnet, dass** das Anpassnetzwerk (16 und 26) mindestens eine Steuerlogik (17.3) aufweist.

9. Schaltungsanordnung gemäß einem der voranstehenden Patentansprüche 6 bis 8, **dadurch gekennzeichnet, dass** das schaltende Element und die Steuerlogik (17.3) im Leistungsverstärker (17, 22 und 23) oder im Frontend Modul integriert sind.

10. Schaltungsanordnung gemäß einem der voranstehenden Patentansprüche 1 bis 9, **dadurch gekennzeichnet, dass** das Anpassnetzwerk (16 und 26) zumindest einen Energiespeicher aufweist, vorzugsweise eine Kapazität (18) und/oder eine Induktivität (19).

11. Schaltungsanordnung gemäß einem der voranstehenden Patentansprüche 1 bis 10, **dadurch gekennzeichnet, dass** das Anpassnetzwerk (16 und 26) aus zumindest einem Phasenschiebernetzwerk (26) besteht, welches die Lastimpedanz am Ausgang (17.2) des Leistungsverstärkers (17, 22 und 23) hinsichtlich der Phase dreht.

12. Schaltungsanordnung gemäß dem voranstehenden Patentanspruch 11, **dadurch gekennzeichnet, dass** das Phasenschiebernetzwerk (26) bei einem Leistungsverstärker (17, 22 und 23) mit integrierter Frontendfunktionalität zusätzlich im Leistungsverstärker (17, 22 und 23) integriert ist und die Zustände des Phasenschiebernetzwerk (26) über Steuersignale einstellbar sind.

13. Schaltungsanordnung gemäß einem der voranstehenden Patentansprüche 11 und 12, **dadurch gekennzeichnet, dass** das Phasenschiebernetzwerk (26) ein analoger Phasenschieber ist.

14. Schaltungsanordnung gemäß einem der voranstehenden Patentansprüche 11 bis 13, **dadurch gekennzeichnet, dass** das Phasenschiebenetzwerk (26) ein digitaler Phasenschieber ist.

15. Verfahren zur Anpassung der Stromaufnahme und der Ausgangsleistung von Leistungsverstärkern (17, 22 und 23) in Mobilfunktelefonen an verschiedene Umgebungsbedingungen, bei dem zumindest ein Leistungsverstärker (17, 22 und 23) Signale an eine Antenne (21) am Ausgang (17.2) des Leistungsverstärkers (17, 22 und 23) ausgibt, wobei die Antenne (21) eine bestimmte Impedanz (20) aufweist und je nach Lastimpedanz am Ausgang (17.2) des Leistungsverstärkers (17, 22 und 23) die Ausgangsleistung und/oder die Stromaufnahme des Leistungsverstärker variieren/variiert, **dadurch gekennzeichnet, dass** mit mindestens einem schaltbaren Anpassnetzwerk (16 und 26) zwischen Ausgang (17.2) des Leistungsverstärkers (17, 22 und 23) und der Antenne (21) die Lastimpedanz am Ausgang (17.2) des Leistungsverstärkers (17, 22 und 23) verändert werden kann.

16. Verfahren gemäß dem voranstehenden Patentanspruch 15, **dadurch gekennzeichnet, dass** mit dem Anpassnetzwerk (16 und 26) zumindest zwei schaltbare Zustände eingestellt werden.

17. Verfahren gemäß dem voranstehenden Patentanspruch 16, **dadurch gekennzeichnet, dass** in einem ersten schaltbaren Zustand eine Lastimpedanz erzeugt wird, bei der der Leistungsverstärker (17, 22 und 23) maximale Ausgangsleistung (2) aufweist.

18. Verfahren gemäß einem der voranstehenden Patentansprüche 16 und 17, **dadurch gekennzeichnet, dass** in einem zweiten schaltbaren Zustand eine Lastimpedanz erzeugt wird, bei der der Leistungsverstärker (17, 22 und 23) maximale Effektivität (5) aufweist.

19. Verfahren gemäß einem der voranstehenden Patentansprüche 15 bis 18, **dadurch gekennzeichnet, dass** das Anpassnetzwerk (16 und 26) frequenzabhängig geschaltet wird.

20. Verfahren gemäß dem voranstehenden Patentanspruch 19, **dadurch gekennzeichnet, dass** das Anpassnetzwerk (16 und 26) in Abhängigkeit der Sendefrequenz des Leistungsverstärkers (17, 22 und 23) geschaltet wird.

21. Verfahren gemäß einem der voranstehenden Patentansprüche 15 bis 20, **dadurch gekennzeichnet, dass** das Anpassnetzwerk (16 und 26) in Abhängigkeit der Temperatur geschaltet wird.

22. Verfahren gemäß einem der voranstehenden Patentansprüche 15 bis 21, **dadurch gekennzeichnet, dass** das Anpassnetzwerk (16 und 26) in Abhängigkeit der Betriebsweise über interne oder externe Antenne geschaltet wird.

23. Verfahren gemäß einem der voranstehenden Patentansprüche 15 bis 22, **dadurch gekennzeichnet, dass** die Lastimpedanz am Ausgang (17.2) des Leistungsverstärkers (17, 22 und 23) hinsichtlich der Phase gedreht wird.

24. Verfahren gemäß dem voranstehenden Patentanspruch 23, **dadurch gekennzeichnet, dass** die Lastimpedanz am Ausgang (17.2) des Leistungsverstärkers (17, 22 und 23) durch analoge Schalttechnik gedreht wird.

25. Verfahren gemäß einem der voranstehenden Patentansprüche 23 und 24, **dadurch gekennzeichnet, dass** die Lastimpedanz am Ausgang (17.2) des Leistungsverstärkers (17, 22 und 23) durch digitale Schalttechnik gedreht wird.
